# EUROPEAN PATENT SPECIFICATION

(11) **EP 1 911 037 B1**
(45) Date of publication and mention of the grant of the patent: **23.09.2009**
(21) Application number: 06780160.5
(22) Date of filing: 21.07.2006
(51) Int. Cl.: G11C 19/28, G11C 19/18

(54) **A MULTIPLE INPUT CIRCUIT**
MULTI-INPUT-KREIS
CIRCUIT A ENTREES MULTIPLES

(30) Priority: 26.07.2005 EP 05106867
(43) Date of publication of application: 16.04.2008
(73) Proprietor: Koninklijke Philips Electronics N.V., 5621 BA Eindhoven (NL)
(72) Inventor: COLLINS, Paul c/o Philips IP & Standards, Redhill Surrey RH1 5HA (GB); DEANE, Steven C. c/o Philips IP & Standards, Redhill Surrey RH1 5HA (GB)
(74) Representative: Schouten, Marcus Maria
(86) International application number: PCT/IB2006/052503
(87) International publication number: WO 2007/013010

(56) References cited:
- EP-A- 1 156 491
- WO-A-98/26423
- US-A1- 2003 052 848

## Description

This invention relates to multiple input circuits, for example shift register circuits for providing the row voltages to the display pixels of an active matrix display device.

Active matrix display devices comprise an array of pixels arranged in rows and columns, and each comprising at least one thin film drive transistor and a display element, for example a liquid crystal cell. Each row of pixels shares a row conductor, which connects to the gates of the thin film transistors of the pixels in the row. Each column of pixels shares a column conductor, to which pixel drive signals are provided. The signal on the row conductor determines whether the transistor is turned on or off, and when the transistor is turned on (by a high voltage pulse on the row conductor) a signal from the column conductor is allowed to pass on to an area of liquid crystal material, thereby altering the light transmission characteristics of the material.

The frame (field) period for active matrix display devices requires a row of pixels to be addressed in a short period of time, and this in turn imposes a requirement on the current driving capabilities of the transistor in order to charge or discharge the liquid crystal material to the desired voltage level. In order to meet these current requirements, the gate voltage supplied to the thin film transistor needs to fluctuate with significant voltage swings. In the case of amorphous silicon drive transistors, this voltage swing may be approximately 30 volts.

The requirement for large voltage swings in the row conductors requires the row driver circuitry to be implemented using high voltage components.

There has been much interest in integrating the components of the row driver circuit onto the same substrate as the substrate of the array of display pixels. This enables narrow seal lines and symmetric display panels. One possibility is to use polycrystalline silicon for the pixel transistors, as this technology is more readily suitable for the high voltage circuit elements of the row driver circuitry. The cost advantages of producing the display array using amorphous silicon technology are then lost.

There is therefore an interest in providing driver circuits which can be implemented using amorphous silicon technology. Integrating the row driver into amorphous silicon would allow a symmetrical display with narrow edges, and provide cost savings compared to low temperature polysilicon processes.

The low mobility of amorphous silicon transistors, as well as the stress-induced change in threshold voltage, present serious difficulties in implementing driver circuits using amorphous silicon technology.

The row driver circuit is conventionally implemented as a shift register circuit, which operates to output a row voltage pulse on each row conductor in turn. Essentially, each stage of the shift register circuit comprises an output transistor connected between a clocked high power line and the row conductor, and the drive transistor is turned on to couple the row conductor to the clocked high power line to generate a row address pulse. A standard row driver design typically comprises a low impedance driver, holding the row to an "off voltage" for just under 100% of the time, while it is pulled to the "row on" voltage for less than 1% of the time. This presents a problem, as amorphous silicon transistors suffer a shift in their threshold voltage that continues to increase the longer the device is held on. The result is a rapidly degrading row driver, after which time the display no longer functions.

In order to ensure that the voltage on the row conductor reaches the power line voltage (despite the series-connected drive transistor), it is known to take advantage of a bootstrapping effect, using a stray capacitance of the output transistor. This is discussed in US 6 052 426.

A problem with the use of the parasitic capacitances of the drive transistor in this way is that there are other stray effects, and these are also discussed in US 6 052 426. One solution to this is to cancel the effect of the stray capacitance by introducing a first additional capacitor, and to introduce a second additional capacitor dedicated to the bootstrapping operation.

Shift register circuits using additional bootstrapping capacitors in this way are disclosed in US 6 052 426 and in US 6 064 713. In these circuits, the gate of the output transistor is charged by the row pulse of the preceding row, through an input transistor. As a result, the maximum gate voltage which can be applied to the output transistor is dependent on the threshold voltage of the input transistor. Particularly when implementing the shift register circuit using amorphous silicon technology, this can become a limiting factor in the performance of the circuit. This is particularly a problem at low temperatures, as the TFT mobility is then at its lowest, and the threshold voltage is at its highest.

The applicant has proposed (but not yet published) a row driver circuit which does not require the row to be held at a fixed voltage. The row can be left to float in a high impedance state after being pre-charged to the row off voltage. The capacitance of the row line and the leakage currents through the drive transistor deliberately provide some leakage current paths to the row off voltage, and this helps stabilise each row and prevent too much interference from neighbouring row lines. One feature of this proposed circuit (which is described in more detail below) is that a complementary clock signal is used to ensure stability during the periods when the row should remain in an off state.

Even though the drive transistor in this circuit operates at a low duty cycle, the threshold voltage variations of the drive transistor still are the eventual cause of limitation to the lifetime of the circuit, and this is more pronounced at extreme temperatures.

According to the invention, there is provided a circuit comprising a first circuit portion controllable by first and second inputs, and a second circuit portion for generating the second input, characterized in that the first circuit portion has first operating characteristics when the second input is provided as control input, and second operating characteristics when the second input is not provided as control input, and wherein the second circuit portion is adapted to cease functioning through ageing before the end of the lifetime of the first portion thereby to switch the first circuit portion from the first to the second operating characteristics.

This circuit uses the failure of a portion of the circuit which generates at least one input control signal, so as to change the overall circuit characteristics as the circuit ages. This approach enables the circuit to be operated with first characteristics which are suitable when the circuit has not aged significantly, and to be operated with second characteristics which are suitable when the circuit has aged and is nearer the end of its life.

The first input may comprise a first clocked power supply line and the second input can comprise an inverted version of the first clocked power supply line. The second circuit portion then comprises an inverter for generating the inverted version of the first clocked power line voltage. This can be designed to fail at a different time to the first circuit portion, and then halt supply of the inverted clock signal.

The circuit can be used as a stage of a shift register circuit which is adapted to pass selected high clock phases of the first clocked power supply line to the output.

For example, each stage may comprise:
a first input connected to the output of a preceding stage;
a drive transistor for coupling a first clocked power line voltage to the output of the stage;
a compensation capacitor for compensating for the effects of a parasitic capacitance of the drive transistor and connected at one terminal to an inverted version of the first clocked power line voltage; and
a first bootstrap capacitor connected between the gate of the drive transistor and the output of the stage,
wherein the inverter is formed on the common substrate.

The inverted clocked power signal is initially used to compensate for parasitic capacitances of the drive transistor. However, this compensation is only required when the threshold voltage of the drive transistor is small, at the beginning of circuit operation. As this threshold voltage drifts, the parasitic capacitance no longer presents a potential limitation to circuit performance.
The invention thus deliberately makes the inverter circuit fail (but in a predictable manner), and this enables the complete lifetime of the circuit to be extended.

The inverter may comprise a pull up transistor connected between the inverter output and a high voltage rail and a pulldown transistor connected between the inverter output and a low voltage rail. This is a simple inverter circuit. The pulldown transistor is then gated by the first clocked power line voltage.

The pull up and pulldown transistors operate with up to approximately 50% duty cycle, and this can result in more rapid threshold voltage drift than the drive transistor of each stage (which only operates during one line time of the frame period), and this makes it possible to design the premature failure of the inverter, even though it is formed using the same technology as the drive transistor. Because the inverter transistors and the drive transistor are subjected to the same environmental conditions, the time of failure of the inverter circuit depends on these conditions in the same way as the drive transistor ageing is dependent on these conditions. In this way, the circuit performance can be maintained. The pulldown transistor may be larger than the pull up transistor, and this is desired because it is subjected to greater voltage stress.

The pull up and pull down transistors are preferably designed to cease functioning through ageing at approximately the same time.

After the inverter ceases functioning, a portion of the first clocked power line voltage is preferably designed to be coupled to the output through a parasitic capacitance of the pulldown transistor, which is dominant over a parasitic capacitance of the pull up transistor. In this way, the failed inverter functions in an opposite manner to the functioning inverter, and the inverter characteristics are beneficial both during the early part of the circuit lifetime and the latter part of the circuit lifetime.

Each stage may further comprise an input transistor for charging the first bootstrap capacitor and controlled by the first input. An input section can be coupled to the output of the stage two or more stages before the stage, and the input section then comprises a second bootstrap capacitor connected between the gate of the input transistor and the first input.

This circuit arrangement uses two bootstrapping capacitors. One is to ensure the full power supply line voltage can be coupled to the output, and the other is for ensuring that the full row voltage from the preceding stage is coupled through the input transistor to the drive transistor during the gate charging step. The circuit has two precharge cycles of operation - a first cycle when the input transistor gate is precharged, and a second cycle when the drive transistor gate is precharged. This makes the circuit less sensitive to threshold voltage levels or variations, and enables implementation using amorphous silicon technology.

The circuit is preferably implemented using amorphous silicon technology, although the circuit can provide advantages for any semiconductor technology where threshold voltage drift is an issue, for example including polymer semiconductor technology.

The shift register circuit of the invention is particularly suitable for use in the row driver circuit of an active matrix display device, for example an active matrix liquid crystal display device.

The invention also provides a method of operating a circuit as described above, the method comprising:
using the second circuit portion to generate from a first input a second input;
controlling the first circuit portion using the first and second inputs to provide first operating characteristics;
characterized by ceasing functioning of the second circuit portion through ageing of the second circuit portion, before the end of the lifetime of the first circuit portion, thereby controlling the first circuit portion without the second input, and thereby providing second operating characteristics.

For example, the method may be used for generating multiple stage shift register circuit outputs. The method may then comprise using the output of the stage one or more stages before the stage to charge the gate of a drive transistor through an input transistor and to charge a first bootstrap capacitor storing the gate-source voltage of the drive transistor; and
coupling a first clocked power supply line voltage to the output of the stage through the drive transistor, the first clocked power supply line voltage comprising the first input.

The second input then comprises an inverted version of the first clocked power line voltage, the second circuit portion comprising an inverter for generating the inverted version of the first clocked power line voltage, and the second input is coupled through a compensation capacitor to the gate of the drive transistor.

The ceasing use may comprise operating the inverter for a time period sufficient that ageing of the components of the inverter result in failure of the inverter function.

An example of the invention will now be described in detail with reference to the accompanying drawings, in which:
Figure 1 shows a known shift register circuit;
Figure 2 shows a first example of shift register circuit proposed by the applicant and which can benefit from the invention;
Figure 3 shows a variation to the circuit of Figure 2 proposed by the applicant;
Figure 4 shows the timing of operation of the circuit of Figure 2;
Figure 5 shows a circuit of the invention;
Figure 6 shows one example of inverter design used in the circuit of Figure 5;
Figure 7 is used to explain the effects of ageing on the circuit of Figure 5;
Figure 8 shows an alternative example of inverter design which can be used in the circuit of Figure 5;
Figure 9 shows a second example of shift register circuit proposed by the applicant and which can benefit from the invention;
Figure 10 shows a variation to the circuit of Figure 9;
Figure 11 shows the timing of operation of the circuit of Figure 9;
Figure 12 shows one example of a known pixel configuration for an active matrix liquid crystal display; and
Figure 13 shows a display device including row and column driver circuitry, in which the circuit and method of the invention can be used.

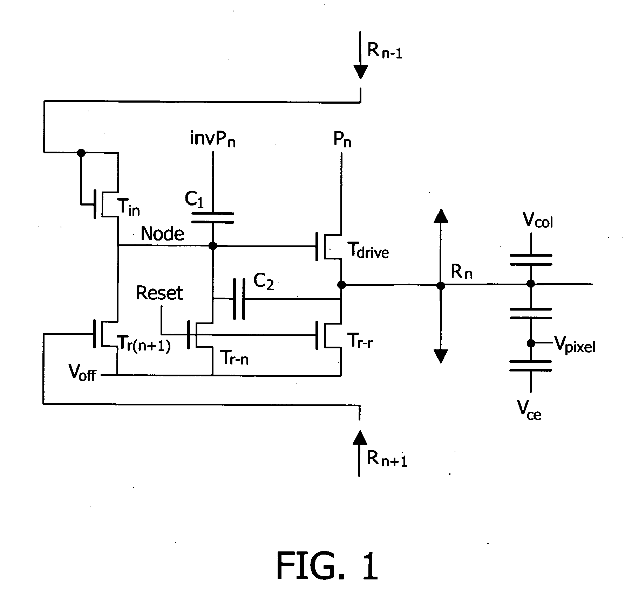

Figure 1 shows a known high impedance gate driver circuit suitable for use in amorphous silicon active matrix liquid crystal displays (AMLCDs). The circuit shown is a single stage of a multiple stage shift register, with each stage being used to supply a row voltage pulse to one row of pixels. A similar circuit has been described in US 6 052 426.

The circuit comprises an output drive transistor T_{drive} coupled between a clocked power line Pₙ and the row conductor Rₙ which is controlled by the stage. The clocked power line (and the complementary signal invPₙ) is a two phase signal (so that there are two different clock signals for adjacent rows), and the cycles of the clocked power line determine the timing of the sequential operation of the shift register stages.

The row pulse on the previous row Rₙ₋₁ is used to charge the output transistor gate through a diode-connected input transistor Tᵢₙ.

A first capacitor C₁ is connected between the output transistor gate and the control line which carries the complementary signal to the clocked power line Pₙ and the purpose of the capacitor C₁ is to offset the effects of internal parasitic capacitances of the output transistor. This is described further below.

An additional bootstrapping capacitor C₂ is provided between the gate of the output transistor and the row conductor (i.e. the output of the stage).

The stage is also controlled by the row pulse on the next row Rₙ₊₁, which is used to turn off the stage by pulling down the gate voltage of the output transistor. The row pulse on the next row Rₙ₊₁ is provided to the gate of the output transistor through an input transistor Tᵣ₍ₙ₊₁₎ associated with the next row conductor signal.

The circuit also has two reset transistors Tᵣ₋ₙ and Tᵣ₋ᵣ which are used when initially powering the circuit.

In operation, the input transistor Tᵢₙ charges the output transistor gate during the previous row pulse. During this previous row pulse, the power line Pₙ is low and the inverse power line invPₙ is high. The output transistor is turned on by this previous row pulse, but as the power line Pₙ is low, the output of the stage remains low.

During this charging stage, the bootstrapping capacitor C₂ is charged to the row voltage pulse (less the threshold voltage of the input transistor Tᵢₙ).

During the next clock cycle, the clock signal Pₙ is high, and this increase in voltage pulls up the output voltage on the row conductor Rₙ through the output transistor. The effect of the bootstrapping capacitor C₂ is to increase the gate voltage to ensure that the full voltage level of the clocked signal Pₙ is passed to the row conductor Rₙ. The transistor Tᵣ₍ₙ₊₁₎ subsequently resets the output transistor gate voltage node during the next row pulse.

In the idle state, the coupling of the inverse power line invPₙ through the first additional capacitor C₁ is designed to prevent the output transistor gate from turning on when the output transistor T_{drive} receives a pulse from Pₙ.

The operation of the circuit as described above will be known to those skilled in the art.

As mentioned above, one limitation of the operation of the circuit of Figure 1 is that the charging of the gate of the output transistor during the timing of the previous row pulse is dependent on the threshold voltage of the input transistor Tᵢₙ. For amorphous silicon transistors, this threshold voltage may be significant, and furthermore may vary significantly with temperature and over time.

An alternative configuration proposed by the applicant uses an additional input section which is coupled to the output of the stage two stages before the stage. This input section comprises a second bootstrap capacitor connected between the gate of the input transistor and the first input, and operates to cancel the effects of the threshold voltage of the input transistor in the charging of the drive transistor gate.

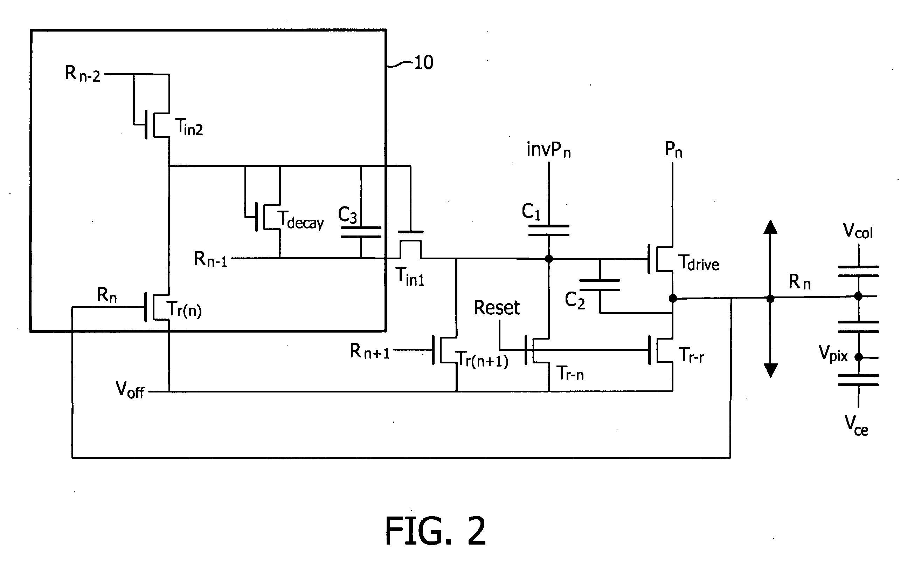

Figure 2 shows one stage of this proposed shift register circuit.

The circuit includes a precharge circuit 10 which is used to sample a TFT threshold voltage onto a second bootstrap capacitor C₃. This is then used to bootstrap the input TFT Tᵢₙ₁, resulting in good charging of the gate of drive transistor gate voltage regardless of the threshold voltage of the input transistor. The row circuit then resets the charge on C₃, so that the input TFT Tᵢₙ₁ does not drift. The other parts of the circuit of Figure 2 are the same as in Figure 1, and a description of these components will not be repeated.

The precharge circuit 10 has an input connected to the output Rₙ₋₂ of the stage two before the stage shown. This output Rₙ₋₂ is coupled through a second input transistor Tᵢₙ₂ to the gate of the first input transistor Tᵢₙ₁.

The second bootstrap capacitor C₃ is connected between the gate of the first input transistor Tᵢₙ₁ and the output of the preceding stage Rₙ₋₁.

A decay transistor T_{decay} is connected in parallel with the second bootstrap capacitor C₃ and is diode-connected. The gate of the decay transistor is connected to the gate of the first input transistor Tᵢₙ₁ so that they experience the same voltage stress. The decay transistor preferably also has substantially the same dimensions as the first input transistor Tin₁.

The precharge section 10 has a reset transistor Tr(n) having its gate connected to the output of the stage Rₙ, for discharging the second bootstrap capacitor C₃.

In operation, the row pulse for the row Rₙ₋₂ two behind the current row is used to charge the gate of the first input transistor Tᵢₙ₁ and the second bootstrap capacitor C₃ via the second input transistor Tᵢₙ₂. This charging is limited by the decay of the charge through the decay transistor T_{decay}.

When row n-2 goes low, the decay transistor T_{decay} causes the voltage across the second bootstrap capacitor C₃ to decay to approximately the TFT threshold voltage. The decay transistor T_{decay} and the first input transistor Tᵢₙ₁ experience the same gate biases at all times, so even in the event of any threshold voltage drift they will exhibit the same threshold voltage.

When row n-1 pulses high, the gate of the first input transistor Tᵢₙ₁ is bootstrapped by the second bootstrap capacitor C₃, resulting in good charging of the gate of the drive transistor T_{drive}.

When row n-1 goes low, the charge is not removed via Tᵢₙ₁ as it is near threshold. Instead, as soon as row n goes high, the discharge transistor Tᵣ₍ₙ₎ discharges the voltage across the second bootstrap capacitor C₃, turning the first input transistor Tᵢₙ₁ completely off.

The circuit operation then proceeds as in the known circuit of Figure 1.

The reset transistor Tᵣ₍ₙ₎ can be placed with its lower side connected to the low voltage line V_{off} (as shown), or it can be connected to the preceding row n-1.

The circuit of Figure 2 benefits from a low number of control lines. One disadvantage is that currents required to charge the capacitances in the circuit are drawn from the row outputs from other stages, and this limits performance.

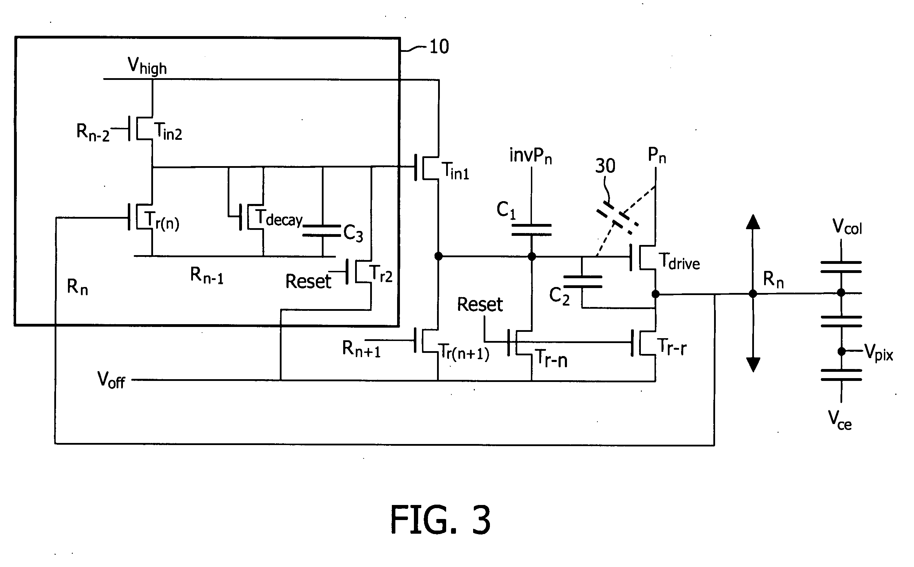

A modification to the circuit of Figure 2 is shown in Figure 3, in which the input transistors Tᵢₙ₁ and Tᵢₙ₂ both couple a dc voltage "V_{high}" to the respective capacitor. An additional reset transistor Tᵣ₂ is shown in the input section 10. The coupling of a high dc voltage is more easily achieved with bottom gate transistor technology. This design reduces the load on the previous row, as the charging currents are drawn from the dc supply. This gives improved circuit performance.

A further benefit of the circuit of Figure 3 is that the circuit can be controlled to provide an idle mode of operation. In an idle state, the circuit presents a high impedance to the row, so that the row pulses can be controlled by a different row driver circuit connected to the other end of the row conductor. It is known to provide two row driver circuits on opposite sides of a display, for example to provide two different modes of operation (different powers, or driving in different directions to allow the display to be used either way up), and an idle mode is required in this case.

The idle mode can be applied to the circuit of Figure 3 by changing V_{high} to V_{off}, and applying the Pn and inverse pulses.

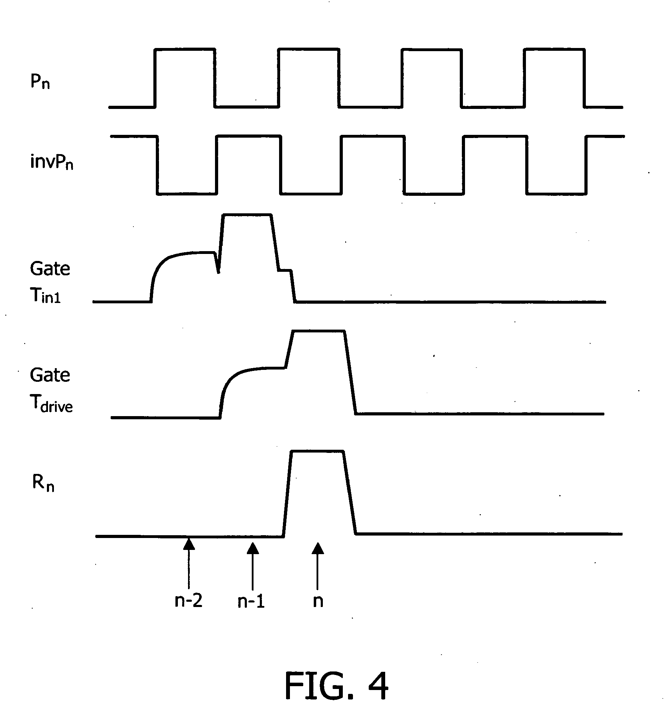

Figure 4 is used to explain schematically the timing principles of operation of the circuit of Figure 2, and the same general principles apply to Figure 3. The plots show the clocked power supply lines, the gate voltage on the first input transistor Tᵢₙ₁, the gate voltage on the drive transistor T_{drive} and the output Rₙ.

During the timing n-2 of the stage two behind, the second bootstrap capacitor C₃ is precharged. At the end of this phase, there is a drop in voltage until the capacitor stores the threshold voltage. This decay of the voltage on the second bootstrap capacitor continues during the application of the output pulse n-1 to the input transistor, and by the end of the output pulse for row n-1, the voltage across the second bootstrap capacitor will have decayed to the threshold voltage, so that threshold compensation is effective for the input transistor, and the full row voltage is used to charge the first bootstrap capacitor.

During the stage n-1, the output of the stage n-1 is capacitively added to the voltage on the second bootstrap capacitor to derive the gate voltage which drives the first input transistor Tᵢₙ₁.

During stage n-1, the first bootstrap capacitor C₂ is also charged, as can be seen from the plot for the drive transistor gate.

During stage n, the clocked power supply line voltage Pₙ is added to the voltage on the first bootstrap capacitor C₂ to derive the gate voltage of the drive transistor T_{drive}.

The beginning of cycle n is used to discharge the second bootstrap capacitor C₃ through the reset transistor Tᵣ₍ₙ₎ controlled by Rₙ.

This invention is concerned with the ageing of the circuits of the type shown in Figures 1 to 3, and in particular concerns the use of the inverse clock signal invPₙ. This inverse clock signal is used to overcome the parasitic capacitance of the drive transistor, and this parasitic capacitance 30 is shown in dotted lines in Figure 3. This can result in a glitch on the gate of the drive transistor, when the clocked power line Pₙ is high. For a two phase clock, the power line Pₙ has a 50% duty cycle, but the drive transistor is only turned on for one row per frame time. If there are 320 lines, this is approximately a 0.3% duty cycle. This glitch may have levels of around 2V, which can cause at least a partial turn on of the drive transistor, thereby coupling the high clock pulse to the output.

This is a particular issue for high temperature operation (e.g. greater than 80 degrees Celsius), because each row driver cell can become too sensitive to variations on the high impedance nodes (namely the gate and output of the drive transistor). This is worse at the beginning of the lifetime of the circuit, when each TFT has a low threshold voltage and therefore can leak significant levels of current onto the high impedance nodes. These effects can then result in multiple rows switching on and therefore pulling quite large current from the clock line.

The invention will be described with reference to the circuit of Figure 3. As outlined above, the purpose of the inverse clock signal invPn is to use the high phases of the clock signal to pull down the voltage on the gate of the drive transistor, and thereby prevent the drive transistor turning on. However, as the threshold voltage of the drive transistor drifts, the glitch on the gate resulting from the parasitic capacitance 30 is less able to result in turn on of the drive transistor. This means that after a certain time, the inverse clock signal Pn is no longer needed. It is only needed for the early lifetime of the circuit, in order to ensure correct operation.

Later in the lifetime of the circuit, the inverse clock signal is not needed. However, it continues to pull down the gate voltage when the signal Pn is high. When the drive transistor is to be turned on, this capacitive coupling still reduces the gate voltage. When there is a certain level of threshold voltage drift in the drive transistor, this reduction in gate voltage become the cause of the drive transistor failing to turn on, and is therefore the eventual cause of the failure of the circuit through ageing.

This is a particular issue for low temperature operation (e.g. less than - 30 degrees Celsius), because the conduction of the input and drive transistors is greatly limited. As the circuit begins to age, the flow of current is limited further due to the increase in threshold voltage. Eventually a situation is reached where a fully charged gate voltage on the drive transistor will not be enough to fully charge the row capacitance. The full "row on" voltage will not be reached and the next row will not be fully pre-charged either, leading to a slowly decaying pulse height down subsequent rows.

The invention is based on the realization that it would be desirable to use the complementary clock signal only at the beginning of the lifetime of the circuit. While it is required at the beginning of the circuit lifetime, it also reduces the high impedance gate voltage nearing the end of the circuit lifetime, and this will ultimately reduce the lifetime, or else require a larger driver circuit to meet given lifetime targets.

The invention provides an approach by which the complementary signals are provided only for a short period, early in the circuit lifetime. The signal then ceases to be present, in order to boost the end of life operation.

The preferred implementation of the invention enables this functionality to be achieved without requiring additional control lines. In particular, an inverter used to generate the inverse clock signal invPₙ is designed to fail, and in a predictable way, as a result of ageing of the inverter circuit itself. The inverter circuit can be designed to fail after a period of time which is such that the initial operation of the circuit has been guaranteed (for example 10's of hours of operation). After the circuit failure, the stray capacitive coupling 30 prolongs the time during which the drive transistor correctly turns on towards the end of the circuit lifetime. This gives the opportunity to reduce the size of the row driver to make a more compact design, and can be achieved without requiring additional clock signals, thereby avoiding additional complexity in wire routing to the driver.

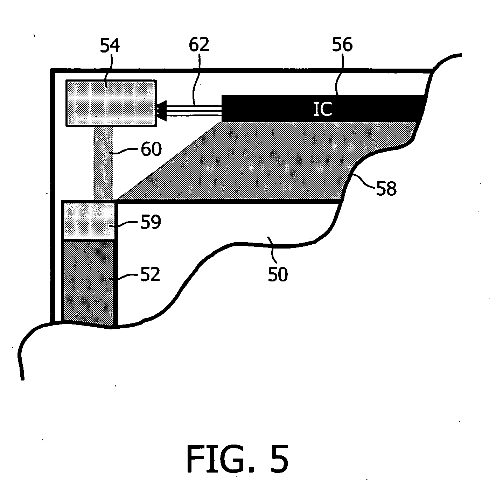

Figure 5 shows a high level block diagram of the inverters on the amorphous silicon panel.

Figure 5 shows the array 50 of pixels, the integrated row driver circuits 52, in the form of an array of shift register circuits as shown in any of Figures 1 to 3, and inverter circuits 54 for generating the inverse clock signals invPₙ. There may, for example, be 320 rows of pixels, and therefore 320 shift register stages. For a two phase clocking system, there are two clock signals and two inverse clock signals needed, so that only two inverter circuits are needed for the whole display device. Figure 5 also shows column driver circuitry 56 and fan out connections 58, as well as a circuit area 59 for providing the start pulse or pulses needed to initiate operation of the shift register circuit. The inverter circuits provide the inverted clock signals 60 to the row driver circuit, and receive the non-inverted clock signals 62.

The inverter circuits 54 can be a standard known design commonly used in NMOS processes.

As mentioned above, a minimum of two clock phases are required, as each shift register circuit uses the outputs from at least one preceding circuits.

For the purposes of explanation, two clock phases will be assumed, and these are each (approximately) 50% duty cycle signals with a 180 degree phase difference. There are guard time periods designed into the clock signals, so that they have a duty cycle slightly below 50%. In some situations, one clock signal could be used as the inverse of the other, but the invention provides inversion of a clock signal to generate the inverse, so that the inversion operation can be designed to fail after a given period of time (as explained above).

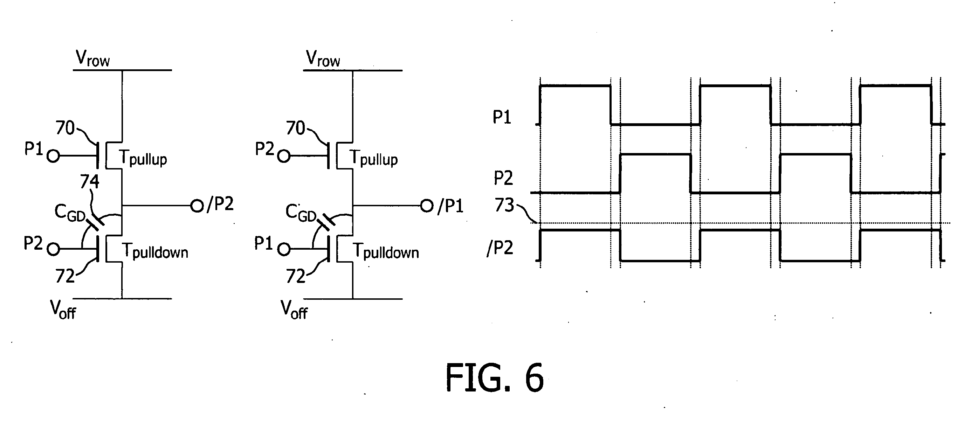

Figure 6 shows two inverter circuits for generating the inverse of the phases P1 and P2. Each inverter circuit comprises a pull up transistor 70 and a pull down transistor 72, in series between the clock high voltage rail Vrow and the row off voltage Voff. The transistors are gated by the two phase signals. The inverter for the phase P1 is pulled up by the phase 2 signal and pulled down by the phase 1 signal, and the inverter for the phase P2 is pulled up by the phase 1 signal and pulled down by the phase 2 signal,

Figure 6 also shows the timing diagram for the inversion of the phase 2 signal, and this shows the duty cycle of each non-inverted clock signal P1 and P2 slightly below 50%. The inverted signal is slightly lengthened compared to the original. Furthermore, the inverted signal does not charge to the full row on voltage 73 as a result of the threshold voltage drop across the pull up transistor.

The inverters are implemented using the same technology as the row driver circuit. At the beginning of the circuit lifetime, both pull up and pull down transistors are resting at their initial threshold voltages, but they begin to age differently from each other due to the difference in gate-source voltages across them. The ageing characteristics of an a-Si TFT mainly result when the device is turned on, and this is worst when the V_{GS} voltage is very large. The pull up transistor will see an initially large gate source voltage as the clock inputs change but this rapidly reduces down to V_{T} once the output is fully charged high, and this limits the time the pull up transistor is stressed. The pull down transistor will always see a constant gate source voltage and as a result will be stressed at the full gate-source voltage for the full line time, creating an asymmetry in the pull up and pull down driving characteristics.

To limit the effects of this problem, the pull down transistor can be scaled accordingly to ensure the positive and negative currents continue to match until failure is desired. In particular, the pull down transistor will be a larger device. This in turn means the parasitic gate drain capacitance 74 will be larger.

When the pull up and pull down transistors have failed, they can thus be arranged to provide an in-phase clock output by capacitive coupling through capacitance 74. This gives to rise to additional capacitive coupling to the clock signal Pn, which assists further in keeping the driver circuit operational. When the inverter circuit fails, the inverter output is always high impedance, but the larger gate-drain capacitance of the pull down transistor couples some of the non-inverted same clock phase input through to the output.

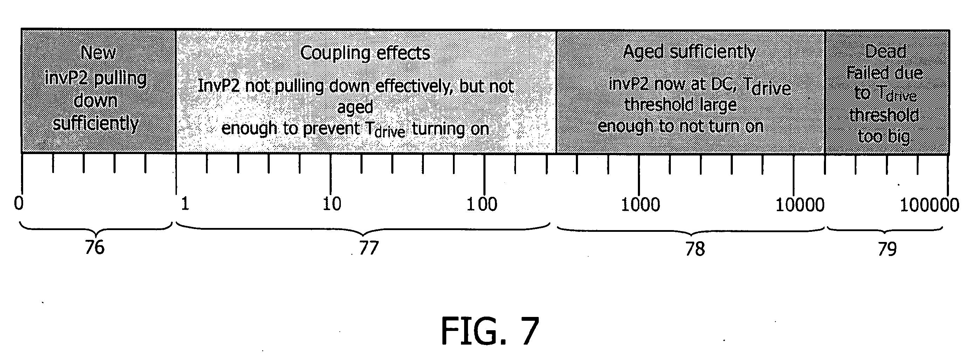

Figure 7 shows a time line to illustrate the effect of ageing on the circuit performance.

During time period 76, the inverters are fully functional, and the inverted clock signal is effective in pulling down the drive transistor gate voltage. After an initial ageing period, of around tens of hours of operation, the inverter starts to fail, so that the inverter is not fully pulling down the drive transistor gate, and this happens during time period 77. However, the drift in the threshold voltage of the drive transistor is such that the less effective coupling of the step voltage on the inverse clock signal through the capacitor C1 does not prevent correct switching of the drive transistor.

During time period 78, from hundreds of hours to thousands or tens of thousands of hours of operation, the inverters have failed, and this means that the non-inverted clock signal is partially coupled to the drive transistor gate. This helps to extend the lifetime during which the drive transistor continues to switch. Only at time period 79 does the circuit completely fail, and this is when the drive transistor threshold has drifted too far to enable switch on of the drive transistor.

Simulations show that the failure of the inverter, and the coupling of part of the non-inverted clock signal through the inverter after failure, enables the driver circuit to withstand significant added threshold stressing (of the drive transistor) before failure, increasing the lifetime by over 20%.

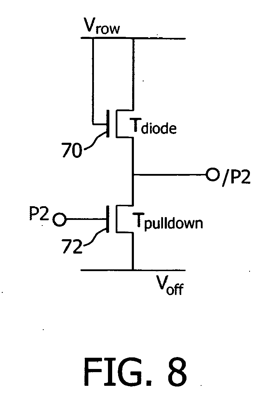

In the example above, two non-overlapping clocks are used by the shift register stages. This is required by the shift register circuit design. The inverter also uses these two different clock signals. However, it is also possible to use only one clock signal as input to the inverter, and a diode connected transistor, as shown in Figure 8. The pull up transistor 70 is in this case a diode-connected transistor. Of course, this circuit will have higher current consumption, but the same ageing process and advantages can be obtained. There are also other inverter circuit designs which may be used.

The generation of the inverted clock signal using thin film circuitry integrated with the row driver circuit does result in non-ideal inverted clock waveforms. In particular, there will be some lag between the clock line coupling onto the drive transistor gate and the subsequent removal of this undesired charge by the inverters. In order to ensure that the inverters are able to remove the coupling from the clock lines quickly enough, before this charge starts to turn on the drive transistors, the inverters should be designed with sufficient scale the inverters to reduce any lag where a low threshold voltage can allow a small leakage of current.

The invention enables lifetimes to be increased, or else enables smaller circuits to be used to achieve given ageing performance requirements. The circuit enables high temperature operation to be guaranteed at the beginning of the circuit life, while also meeting the end of life operation at low temperatures. Furthermore, the same control signals are used throughout the life of the circuit, so that no feedback control signal representing time or other conditions is required. The inverter circuits effectively provide an element of time feedback, by virtue of their failure after a period of time (of the order of 100 hours), in order to change the functionality of the circuit.

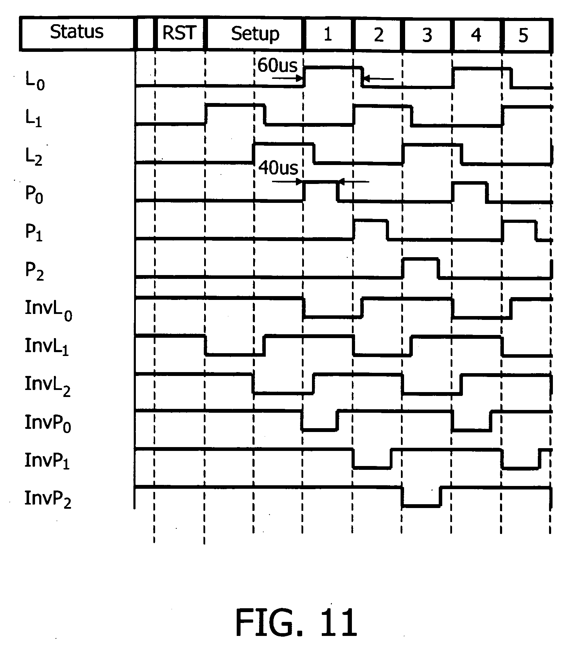

The timing diagram of Figure 4 uses two phase clocking. In practice, the implementation of the circuit of Figure 3 may use three phase clocking. In other words, the values of Pₙ₋₂ and Pₙ are no longer the same. An example of three phase clocking is shown in Figure 11, described below.

The use of a dc voltage in Figure 3 in particular requires the three phase control signals to prevent C3 and C2 both charging during the Rₙ₋₂ row pulse.

An alternative approach is to adapt the input stage so that it is not limited to raising the effective gate drive voltage of Tᵢₙ by its threshold voltage, but can raise the drive voltage by a much larger amount. This further improves the charging of the circuit capacitance nodes, and so improves operation.

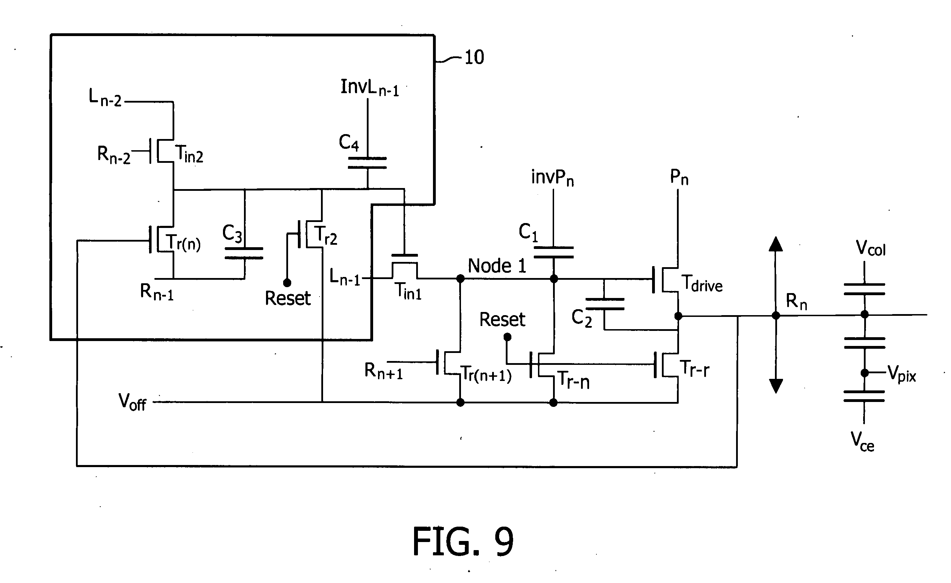

Figure 9 shows one stage of a shift register circuit modified in this way.

The circuit is the same as the circuit of Figure 2, apart from the input section 10, and a description of the repeated circuit components will not be given.

The input section 10 again has a second input transistor Tᵢₙ₂ which supplies a signal with timing based on the output of the stage two stages before the stage to the gate of the first input transistor Tᵢₙ₁. In the circuit of Figure 9, the output Rₙ₋₂ two stages before controls the timing, but a different voltage waveform is applied to the drain of the second input transistor Tᵢₙ₂, and this is shown as Lₙ₋₂. This will be called a second input line.

Similarly, the first input transistor Tᵢₙ₁ is connected between a first input line Lₙ₋₁ and the gate of the drive transistor T_{drive}. The input line Lₙ₋₁ is high when the output of the stage before is high, so that the operation is similar to Figure 2. However, for reasons explained below, the input Lₙ₋₁ is also high immediately after the output of the stage before has had a transition from high to low.

The first and second input lines may be clocked signals, but they can be delayed versions of each other, so that there is effectively only one additional clocked signal for each phase of the input clocks Pn. Alternatively, dc voltages may be used.

As in the circuit of Figure 2, the second bootstrap capacitor C₃ is connected between the output Rₙ₋₁ of the previous stage and the gate of the first input transistor Tᵢₙ₁, and this second bootstrap capacitor is charged with timing based on the output of the stage two stages before. However, there is no decay transistor, so that the charge on the second bootstrap capacitor is not limited to a threshold voltage, but can instead be selected based on the voltage of the input Lₙ₋₂ minus the threshold voltage of Tᵢₙ₂.

An (optional) input section reset transistor Tᵣ₂ is connected between the gate of the first input transistor Tᵢₙ₁ and the low power line V_{off}, and this is for reset of the driver.

The gate of the first input transistor Tᵢₙ₁ may be connected to a clocked signal which is the inverse of the first input line Lₙ₋₁ through a capacitor C₄, and this is to prevent the rising edge of Lₙ₋₁ coupling through the parasitic gate-drain capacitance of Tᵢₙ₁ and turning it on. The capacitor C₄ couples in a complementary signal that cancels this effect out, and the value of C₄ is accordingly chosen to be proportional to the capacitance of Tᵢₙ₁ with the same proportionality as between C₁ and the drive transistor.

In the embodiment of Figure 9, the input section feedback reset transistor Tᵣ₍ₙ₎ is connected between the gate of the first input transistor Tᵢₙ₁ and the output of the preceding stage Rₙ₋₁, and again has its gate connected to the output of the stage, for discharging the second bootstrap capacitor C₃.

In operation of the circuit of Figure 9, the high pulse of the output of the stage two stages behind Rₙ₋₂ again charges the second bootstrap capacitor C₃ through the second input transistor Tᵢₙ₂. The second input line Lₙ₋₂ is high during this time. There is no decay transistor to limit the charging. Thus, instead of charging C₃ to a threshold voltage, it may charge to the voltage of the second input line, less the threshold voltage of the second input transistor. This second input line will typically carry the row voltage, but the timing is not the same, as explained below.

When the preceding stage output Rₙ₋₁ pulses high, and the first input line Lₙ₋₁ is also high, the gate of the first input transistor Tᵢₙ₁ is bootstrapped by the second bootstrap capacitor C₃, resulting in very good charging of the gate of the drive transistor T_{drive}.

When the output Rₙ₋₁ goes low, the charge is not removed from the first bootstrap capacitor C₂ via Tᵢₙ₁ as Lₙ₋₁ is arranged to remain high until after C₃ is discharged. This is the reason why different timing is needed for the first input Lₙ₋₁ than the timing of the output Rₙ₋₁, even though the voltage levels can be the same. As soon as row N goes high, the feedback reset transistor Tᵣ₍ₙ₎ discharges the voltage across C₃, turning Tᵢₙ₁ completely off, in the same way as for the embodiment of Figure 2..

The circuit operation proceeds in the same way as explained above.

The circuit of Figure 9 has the same number of TFTs as in Figure 2, but some extra clock lines are required. However, the bootstrapping of the first input transistor Tᵢₙ₁ is far better.

If the TFT technology has sufficiently good switching characteristics, a DC voltage equivalent to the row high voltage may replace the clocked signals Lₙ.

In this case, the capacitor C₄ and the inverted clocks Lₙ are not required, and circuit performance is improved even further.

The circuit of Figure 9 has the same further benefits mentioned above that the internal capacitance nodes draw their charging current from the clock lines Ln, rather than the previous rows. This decreases the load which needs to driven by each output TFT.

This circuit also has the benefit that by applying appropriate signals, the row driver may remain in the idle state, while another row driver drives the display with a differing pulse sequence. As mentioned above, this can be used, for example, to provide a display that can scan in forwards or reverse directions.

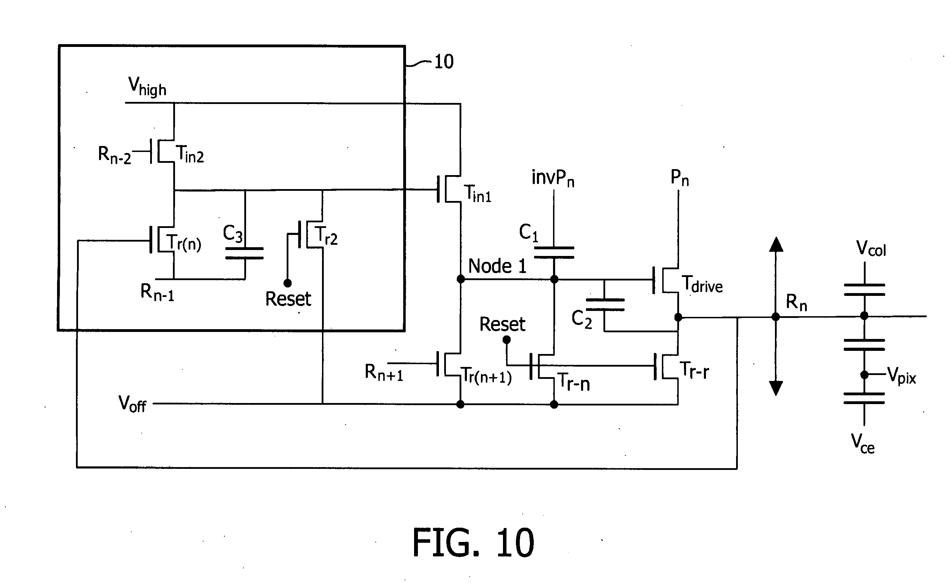

Figure 10 shows a modification to the circuit of Figure 9, in which dc voltages are again used in place of the timing signals Ln, and this is again most appropriate for bottom gate technology. This reduces the clock count and avoids the need for the capacitance C₄. The circuit can be idled in the same way as explained with reference to Figure 3.

Figure 11 shows a clock timing diagram for the circuit of Figure 9, and shows signals for the input lines L for three successive rows as well as signals for the power lines for the three successive rows.

As shown, the pulses on the input lines L have a duration longer than the row address period, and this duration is shown by way of example as 60µs. The clocked power line pulses are shorter, shown by way of example as 40µs.

The signals shown in the timing diagram have repeating pulses, so that only three different power P and input line L waveforms and their complements are needed to address the full array.

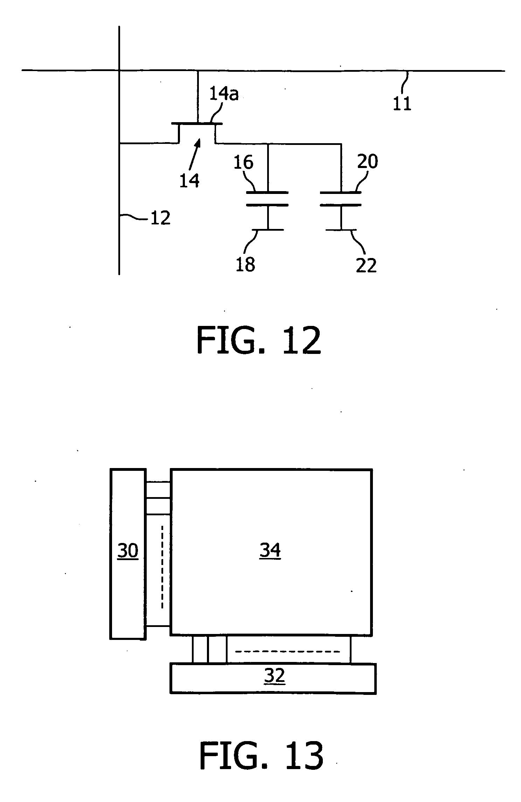

Figure 12 shows a conventional pixel configuration for an active matrix liquid crystal display. The display is arranged as an array of pixels in rows and columns. Each row of pixels shares a common row conductor 11, and each column of pixels shares a common column conductor 12. Each pixel comprises a thin film transistor 14 and a liquid crystal cell 16 arranged in series between the column conductor 12 and a common electrode 18. The transistor 14 is switched on and off by the signals provided on the row conductors 11, as described above. Each pixel additionally comprises a storage capacitor 20 which is connected at one end 22 to the next row electrode, to the preceding row electrode, or to a separate capacitor electrode. This capacitor 20 stores a drive voltage so that a signal is maintained across the liquid crystal cell 16 after the transistor 14 has been turned off.

In order to drive the liquid crystal cell 16 to a desired voltage to obtain a required gray level, an appropriate signal is provided on the column conductor 12 in synchronism with the row address pulse on the row conductor 11. This row address pulse turns on the thin film transistor 14, thereby allowing the column conductor 12 to charge the liquid crystal cell 16 to the desired voltage, and also to charge the storage capacitor 20 to the same voltage. At the end of the row address pulse, the transistor 14 is turned off, and the storage capacitor 20 maintains a voltage across the cell 16 when other rows are being addressed. The storage capacitor 20 reduces the effect of liquid crystal leakage and reduces the percentage variation in the pixel capacitance caused by the voltage dependency of the liquid crystal cell capacitance.

The rows are addressed sequentially so that all rows are addressed in one frame period, and refreshed in subsequent frame periods.

As shown in Figure 13, the row address signals are provided by row driver circuitry 30, and the pixel drive signals are provided by column address circuitry 32, to the array 34 of display pixels. The circuit of the invention is suitable for use in the row driver circuitry, and manufactured using amorphous silicon technology. The circuit elements can then be integrated onto the active matrix display substrate.

In the example above, the reset transistor Tᵣ₍ₙ₊₁₎ controlled by the next stage is connected between the gate of the drive transistor and the low power line. It may instead be connected between the gate of the drive transistor and the row output, namely across the first bootstrap capacitor C₂. Furthermore, this reset transistor could be connected to the output of a different output stage, for example stage n+2, n+3 etc (up to n + number of clock phases -1).

As will be apparent from the two examples above, the reset transistor Tᵣ₍ₙ₎ of the input section can be connected between the gate of the first input transistor Tᵢₙ₁ and the low power line V_{off} or between the gate of the first input transistor Tᵢₙ₁ and the preceding row output n-1, namely across the second bootstrap capacitor C₃. These two possibilities are possible for both examples shown. The gate of this reset transistor could also be connected to the output of a different output stage, for example stage n+1, n+2 etc. The circuits can also function without the reset transistor at all.

In the example of Figure 9, the second input transistor Tᵢₙ₂ can be diode-connected as in the example of Figure 2, thereby removing the connection to Lₙ₋₂. Thus, the embodiment of Figure 9 does not need connection to the second input line Lₙ₋₂. The connection to Lₙ₋₂ provides the ability of the circuit to remain in an idle state, while the display is driven differently, as mentioned above.

Some of the detailed examples above use the output from two stages behind as a control signal. However, the double-precharge effect can be achieved using an output from a stage further back. For example, instead of using Rn-1 and Rn-2 as in the examples above, the circuit may be designed to use Rn-2 and Rn-4. This may be desirable if the gate driver is split into odd and even halves, each on different sides of the array. This example also shows that the gate charging controlled by the output of the preceding stage in the examples shown, can in fact also be controlled by a stage further back.

As mentioned above, the invention is particularly suitable for implementation using amorphous silicon transistors, and for this reason, the circuits shown use n-type transistors. However, the invention is also applicable to other circuit technologies, for example organic thin film transistors (which are frequently implemented as p-type devices) or low temperature polysilicon (which may be implemented as PMOS devices). The circuits of the invention can implemented using p-type transistors without modification to the operating principles, and this will be well understood by those skilled in the art. The invention is not intended to be limited to any particular technology type, but can be applied to any technology where ageing effects provide a limit to the circuit lifetime. This is particularly pronounced in amorphous silicon devices.

As mentioned above, the pull up transistor of the inverter circuit will be smaller than the pulldown transistor, so that the capacitive coupling through the pulldown transistor is greater, and so that the two devices fail at approximately the same time, in terms of their threshold voltage drift. Typically, the pulldown transistor will occupy a substrate area 1.5 -10 times larger, more preferably 2-5 times larger, than the area occupied by the pull up transistor.

The transistors of the inverter are significantly larger than the drive transistors of the shift register stages, for example the pulldown transistor may occupy an area 5 -50 times larger than the area occupied by each drive transistor.

The detailed examples above relate to the application of the invention to row driver shift register circuits. However, the invention can be applied to other multiple input circuits, and generally relates to a circuit in which one or more selected inputs are disabled during the lifetime of the overall circuit, but designing a circuit which generates one or more control inputs to fail. This approach can enable the performance of a circuit to be tuned to the age of a circuit in many different applications, and enables this tuning without additional feedback signals. The ageing issue which is addressed by the invention is of particular benefit for amorphous silicon technology, but the invention can provide advantages for any semiconductor technology where ageing, particularly threshold voltage drift, is an issue, for example including polymer semiconductor technology.

In connection with the example of row driver shift register circuits, the invention can be applied to each of the row driver shift register circuits described, but can also be applied to other examples. For use in row driver circuits, the invention relates in particular to the generation of an inverse clock signal of a shift register circuit control clock signal, using an inverter which fails before the shift register circuit fails.

In the row driver shift register circuits, to save space and power, the drive transistor is likely to be made in the finest definition process available. Inevitably, this will lead to some variation in the parasitic capacitance due to line width variations, which can lead to poor matching with the value of the compensation capacitor C₁, and subsequent restrictions in the circuit operational range. In addition, the size of the compensation capacitor C1 is a compromise, and can be optimised for high temperature (larger) or for low temperature operation (smaller), but not both at the same time.

One additional measure which can be employed to address these issues is to make the amplitude of the inverted clock signal invPₙ separately alterable from the height of the clock signal Pₙ, so that it can be altered to suit the dimensions of a device made with a particular process variation. This has the same electrical effect as changing the size of the compensation capacitor C1. This adjustment can be made after manufacture, whereas changing the size of the compensation capacitor C₁ would require a mask redesign, and would not be able to address unexpected process variations, for example line width variations. This variable amplitude inverted clock signal invPₙ has further benefits in that the amplitude can be altered to suit the ambient conditions. For example, it can be increased at high temperatures to extend the upper temperature limit of circuit operation, and it can be reduced at low temperatures to extend the lower limit of circuit operation.

It will be apparent that there are numerous variations to the specific circuits described in detail, and many other modifications will be apparent to those skilled in the art, as well as many other applications in which the invention can be used.

## Claims

1. A circuit comprising a first circuit portion (52) controllable by first and second inputs, and a second circuit portion (54) for generating the second input, **characterized in that**
the first circuit portion (52) has first operating characteristics when the second input (invPₙ) is provided as control input, and second operating characteristics when the second input (invPₙ) is not provided as control input, and wherein the second circuit portion (54) is adapted to cease functioning through ageing before the end of the lifetime of the first circuit portion (52) thereby to switch the first circuit portion from the first to the second operating characteristics.

2. A circuit as claimed in claim 1, wherein the first input comprises a first clocked power supply line (Pₙ) and the second input (invPₙ) comprises an inverted version of the first clocked power supply line (Pₙ), wherein the second circuit portion (54) comprises an inverter (70,72) for generating the inverted version of the first clocked power line voltage.

3. A shift register circuit comprising a plurality of stages provided on a common substrate, wherein each stage comprises a circuit as claimed in claim 2, each stage being controlled by the first clocked power supply line (Pₙ) and the inverted version (invPₙ) of the first clock power supply line, and wherein each circuit as claimed in claim 2 is adapted to pass selected high clock phases of the first clocked power supply line to its output.

4. A shift register circuit as claimed in claim 3, wherein each stage comprises:
a first input (Rₙ₋₁) connected to the output of a preceding stage;
a drive transistor (T_{drive}) for coupling a first clocked power line voltage (Pₙ) to the output (Rₙ) of the stage;
a compensation capacitor (C₁) for compensating for the effects of a parasitic capacitance of the drive transistor and connected at one terminal to an inverted version (invPₙ) of the first clocked power line voltage; and
a first bootstrap capacitor (C₂) connected between the gate of the drive transistor and the output (Rₙ) of the stage,
wherein the inverter is formed on the common substrate.

5. A shift register circuit as claimed in claim 4, wherein the inverter comprises a pull up transistor (70) connected between the inverter output and a high voltage rail and a pulldown transistor (72) connected between the inverter output and a low voltage rail.

6. A shift register circuit as claimed in claim 5, wherein the pulldown transistor (72) is gated by the first clocked power line voltage.

7. A shift register circuit as claimed in claim 5 or 6, wherein the pull up and pulldown transistors operate with approximately 50% duty cycle.

8. A shift register circuit as claimed in any one of claims 5 to 7, wherein the pulldown transistor (72) is larger than the pull up transistor (70).

9. A shift register circuit as claimed in any one of claims 5 to 8, wherein the pull up and pull down transistors are designed to cease functioning through ageing at approximately the same time (78).

10. A shift register circuit as claimed in any one of claims 5 to 9, wherein after the inverter ceases functioning (78), a portion of the first clocked power line voltage is coupled to the output through a parasitic capacitance (C_{GD}) of the pulldown (72) transistor, which is dominant over a parasitic capacitance of the pull up transistor.

11. A shift register circuit as claimed in any one of claims 4 to 10, wherein each stage further comprises:
an input transistor (Tᵢₙ₁) for charging the first bootstrap capacitor (C₂) and controlled by the first input (Rₙ₋₁).

12. A shift register circuit as claimed in any one of claims 4 to 11, wherein each stage further comprises an input section (10) coupled to the output (Rₙ₋₂) of the stage two or more stages before the stage, and wherein the input section comprises a second bootstrap capacitor (C₃) connected between the gate of the input transistor (Tᵢₙ₁) and the first input (Rₙ₋₁ ).

13. A shift register circuit as claimed in claim 12, wherein the input section is coupled to the output (Rₙ₋₂) of the stage two stages before the stage.

14. A shift register circuit as claimed in any one of claims 4 to 13, wherein each stage further comprises a second input (Rₙ₊₁) connected to the output of the next stage.

15. A shift register circuit as claimed in any one of claims 4 to 14, wherein the compensation capacitor (C₁) of each stage is connected between the gate of the drive transistor and the inverted version (invPₙ) of the first clocked power line voltage.

16. A shift register circuit as claimed in any preceding claim, implemented using amorphous silicon technology.

17. An active matrix display device, comprising:
an array of active matrix display pixels;
row driver circuitry comprising a shift register circuit as claimed in any one of claims 3 to 15.

18. An active matrix display device as claimed in claim 17, comprising an active matrix liquid crystal display device.

19. A method of operating a circuit, the circuit being as claimed in claim 1, the method comprising:
using the second circuit portion (54) to generate from a first input (Pₙ) a second input (invPₙ);
controlling the first circuit portion (52) using the first and second inputs to provide first operating characteristics;
**characterized by** ceasing functioning of the second circuit portion (54) through ageing of the second circuit portion, before the end of the lifetime of the first circuit portion (52), thereby controlling the first circuit portion without the second input, and thereby providing second operating characteristics.

20. A method of generating multiple stage shift register circuit outputs, comprising, for each stage of the shift register circuit, using the method of claim 19,
wherein the method comprises using the output of the stage one or more stages before the stage to charge the gate of a drive transistor (T_{drive}) through an input transistor (Tᵢₙ₁) and to charge a first bootstrap capacitor (C₂) storing the gate-source voltage of the drive transistor; and
coupling a first clocked power supply line voltage (Pₙ) to the output of the stage through the drive transistor, the first clocked power supply line voltage comprising the first input,
and wherein the second input comprises an inverted version (invPₙ) of the first clocked power line voltage, the second circuit portion comprising an inverter (70,72) for generating the inverted version of the first clocked power line voltage, and wherein the second input (invPₙ) is coupled through a compensation capacitor (C₁) to the gate of the drive transistor.

21. A method as claimed in claim 20, wherein the ceasing use comprises operating the inverter (70,72) for a time period sufficient that ageing of the components of the inverter result in failure of the inverter function.

22. A method as claimed in claim 20 or 21, further comprising using the output (Rₙ₋₂) of the stage two or more stages before the stage to charge the gate of an input transistor (Tᵢₙ₁), and storing the gate-source voltage on a second bootstrap capacitor (C₃).

## Patentansprüche

1. Schaltungsanordnung mit einem ersten, von einem ersten und einem zweiten Eingang steuerbaren Schaltungsteil (52) und einem zweiten Schaltungsteil (54) zum Erzeugen des zweiten Eingangs, **dadurch gekennzeichnet, dass** der erste Schaltungsteil (52) erste Betriebskenndaten aufweist, wenn der zweite Eingang (invPₙ) als Steuereingang vorgesehen ist, und zweite Betriebskenndaten, wenn der zweite Eingang (invPₙ) nicht als Steuereingang vorgesehen ist, und wobei der zweite Schaltungsteil (54) dazu vorgesehen ist, vor dem Ende der Lebenszeit des ersten Schaltungsteils (52) das Funktionieren durch Alterung zu beenden, und zwar **dadurch**, dass der erste Schaltungsteil aus den ersten in die zweiten Betriebskenndaten geschaltet wird.

2. Schaltungsanordnung nach Anspruch 1, wobei der erste Eingang eine erste getaktete Speiseleitung (Pₙ) und der zweite Eingang (invPₙ) eine invertierte Version der ersten getakteten Speiseleitung (Pₙ) aufweist, wobei der zweite Schaltungsteil (54) einen Inverter (70, 72) zum Erzeugen der invertierten Version der ersten getakteten Speiseleitungsspannung aufweist.

3. Schieberegisterschaltung mit einer Anzahl auf einem gemeinsamen Substrat vorgesehener Stufen, wobei jede Stufe eine Schaltungsanordnung nach Anspruch 2 aufweist, wobei jede Stufe von der ersten getakteten Speiseleitung (Pₙ) und der invertierten Version (invPₙ) der ersten getakteten Speiseleitung gesteuert wird und wobei jede Schaltungsanordnung nach Anspruch 2 dazu vorgesehen ist, selektierte hohe Taktphasen der ersten getakteten Speiseleitung zu dem Ausgang durchzulassen.

4. Schieberegisterschaltung nach Anspruch 3, wobei jede Stufe Folgendes umfasst:
- einen ersten Eingang (Rₙ₋₁), der mit dem Ausgang einer vorhergehenden Stufe verbunden ist,
- einen Treibertransistor (T_{drive}) zur Kopplung einer ersten getakteten Speiseleitungsspannung (Pₙ) zu dem Ausgang (Rₙ) der Stufe,
- einen Ausgleichkondenstor (C₁) zum Ausgleichen der Effekte einer Streukapazität des Treibertransistors, wobei dieser Kondensator mit einem Anschluss mit einer invertierten Version (invPₙ) der ersten getakteten Speiseleitungsspannung verbunden ist, und
- einen ersten Bootstrap-Kondensator (C₂), der zwischen dem Gate des Treibertransistors und dem Ausgang (Rₙ) der Stufe vorgesehen ist,
wobei der Inverter auf dem gemeinsamen Substrat vorgesehen ist.

5. Schieberegisterschaltung nach Anspruch 4, wobei der Inverter einen Pullup-Tran-sistor (70) aufweist, der zwischen dem Inverterausgang und einer Hochspannungsschiene vorgesehen ist, und einen Pulldown-Transistor (72), der zwischen dem Inverterausgang und einer Niederspannungsschiene vorgesehen ist.

6. Schieberegisterschaltung nach Anspruch 5, wobei der Pulldown-Transistor (72) von der ersten getakteten Speiseleitungsspannung angesteuert wird.

7. Schieberegisterschaltung nach Anspruch 5 oder 6, wobei der Pullup-Transistor und der Pulldown-Transistor in einem 50% Arbeitszyklus arbeiten.

8. Schieberegisterschaltung nach einem der Ansprüche 5 bis 7, wobei der Pulldown-Transistor (72) größer ist als der Pullup-Transistor (70).

9. Schieberegisterschaltung nach einem der Ansprüche 5 bis 8, wobei der Pullup-Transistor und der Pulldown-Transistor derart entworfen sind, etwa zur gleichen Zeit (78) durch Alterung das Funktionieren zu beenden.

10. Schieberegisterschaltung nach einem der Ansprüche 5 bis 9, wobei nachdem der Inverter das Funktionieren (78) beendet hat, ein Teil der ersten getakteten Speiseleitungsspannung über eine Streukapazität (C_{GD}) des Pulldown-Transistors (72) zu dem Ausgang gekoppelt wird, wobei die genannte Streukapazität gegenüber der Streukapazität des Pullup-Transistors überwiegend ist.

11. Schieberegisterschaltung nach einem der Ansprüche 4 bis 10, wobei jede Stufe weiterhin Folgendes umfasst:
- einen Eingangstransistor (Tᵢₙ₁) zum Laden des ersten Bootstrap-Kondensators (C₂), gesteuert von dem ersten Eingang (Rₙ₋₁).

12. Schieberegisterschaltung nach einem der Ansprüche 4 bis 11, wobei jede Stufe weiterhin einen Eingangsteil (10) aufweist, der mit dem Ausgang (Rₙ₋₂) der Stufe, zwei oder mehr Stufen vor der Stufe gekoppelt ist, und wobei der Eingangsteil einen zweiten Bootstrap-Kondensator (C₃) aufweist, der zwischen dem Gate des Eingangstransistors (Tᵢₙ₁) und dem ersten Eingang (Rₙ₋₁) vorgesehen ist.

13. Schieberegisterschaltung nach Anspruch 12, wobei der Eingangsteil mit dem Ausgang (Rₙ₋₂) der Stufe zwei Stufen vor der Stufe gekoppelt ist.

14. Schieberegisterschaltung nach einem der Ansprüche 4 bis 13, wobei jede Stufe weiterhin einen zweiten Eingang (Rₙ₊₁) aufweist, der mit dem Ausgang der nächsten Stufe verbunden ist.

15. Schieberegisterschaltung nach einem der Ansprühe 4 bis 14, wobei der Ausgangkondensator (C₁) jeder Stufe zwischen dem Gate des Treibertransistors und der invertierten Version (invPₙ) der ersten getakteten Speiseleitungsspannung vorgesehen ist.

16. Schieberegisterschaltung nach einem der vorstehenden Ansprüche, implementiert unter Anwendung amorpher Siliziumtechnologie.

17. Aktiv-Matrix-Wiedergabeanordnung, die Folgendes umfasst:
- eine Anordnung von Aktiv-Matrix-Display-Pixeln
- eine Reihentreiberschaltung mit einer Schieberegisterschaltung nach einem der Ansprüche 3 bis 15.

18. Aktiv-Matrix-Wiedergabeanordnung nach Anspruch 17 mit einer Aktiv-Matrix-Flüssigkristallwedergabeanordnung.

19. Verfahren zum Betreiben einer Schaltungsanordnung nach Anspruch 1,
wobei das Verfahren die nachfolgenden Verfahrensschritte umfasst:
- das Verwenden eines zweiten Schaltungsteils (54) zum Erzeugen eines zweiten Eingangs (invPₙ) aus einem ersten Eingang (Pₙ),
- das Steuern des ersten Schaltungsteils (52) unter Verwendung des ersten und des zweiten Eingangs zum Schaffen erster Betriebskenndaten,
**gekennzeichnet durch** das Beenden des Funktionierens des zweiten Schaltungsteils (54) durch Alterung des zweiten Schaltungsteils, und zwar vor dem Ende der Lebenszeit des ersten Schaltungsteils(52), wodurch der erste Schaltungsteil ohne den zweiten Eingang gesteuert wird, und wodurch zweite Betriebskenndaten geschaffen werden.

20. Verfahren zum Erzeugen von Mehrstufen-Schieberegisterschaltungsausgängen, wobei für jede Stufe der Schieberegisterschaltung das Verfahren nach Anspruch 19 angewandt wird, wobei das Verfahren die nachfolgenden Verfahrensschritte umfasst:
- das Verwenden des Ausgangs der Stufe eine oder mehrere Stufen vor der Stufe zum Laden des Gates eines Treibertransistors (T_{drive)} über einen Eingangstransistor (Tᵢₙ₁) und zum Laden eines ersten Bootstrap-Kondensators (C₂), der die Gate-Source-Spannung des Treibertransistors speichert, und
- das Koppeln einer ersten getakteten Speiseleitungsspannung (Pₙ) zu dem Ausgang der Stufe über den Treibertransistor, wobei die erste getaktete Speiseleitungsspannung den ersten Eingang aufweist, und wobei der zweite Eingang eine invertierte Version (invPₙ) der ersten getakteten Speiseleitungsspannung aufweist, wobei der zweite Schaltungsteil einen Inverter (70, 72) zum Erzeugen der invertierten Version der ersten getakteten Speiseleitungsspannung aufweist, und wobei der zweite Eingang (invPₙ) über einen Ausgleichkondensator (C₁ mit dem Gate des Treibertransistors gekoppelt ist.

21. Verfahren nach Anspruch 20, wobei das Beenden des Gebrauchs das Funktionieren des Inverters (70, 72) für eine Zeitperiode umfasst, die ausreicht, dass Alterung der Elemente des Inverters zu einem Aussetzen der Inverterfunktion führt.

22. Verfahren nach Anspruch 20 oder 21, wobei dieses Verfahren weiterhin das Verwenden des Ausgangs (Rₙ₋₂) der Stufe zwei oder mehr Stufen vor der Stufe umfasst, und zwar zum Laden des Gates eines Eingangstransistors (Tᵢₙ₁), sowie das Speichern der Gate-Source-Spannung in einem zweiten Bootstrap-Kondensator (C₃).

## Revendications

1. Circuit comprenant une première partie de circuit (52) contrôlable par une première et une seconde entrée, et une seconde partie de circuit (54) pour générer la seconde entrée, **caractérisé en ce que** :
la première partie de circuit (52) comporte des premières caractéristiques de fonctionnement quand la seconde entrée (invPₙ) est fournie comme une entrée de contrôle, et des secondes caractéristiques de fonctionnement quand la seconde entrée (invPₙ) n'est pas fournie comme une entrée de contrôle, et dans lequel la seconde partie de circuit (54) est adaptée pour cesser de fonctionner par vieillissement avant la fin de la durée de vie de la première partie de circuit (52), pour commuter ainsi la première partie de circuit des premières aux secondes caractéristiques de fonctionnement.

2. Circuit selon la revendication 1, dans lequel la première entrée comprend une première ligne d'alimentation électrique cadencée (Pₙ) et la seconde entrée (invPₙ) comprend une version inversée de la première ligne d'alimentation électrique cadencée (Pₙ), dans lequel la seconde partie de circuit (54) comprend un inverseur (70, 72) pour générer la version inversée de la première tension de ligne électrique cadencée.

3. Circuit de registre à décalage comprenant une pluralité de phases fournies sur un substrat commun, dans lequel chaque phase comprend un circuit selon la revendication 2, chaque phase étant contrôlée par la première ligne d'alimentation électrique cadencée (Pₙ) et la version inversée (invPₙ) de la première ligne d'alimentation électrique cadencée, et dans lequel chaque circuit selon la revendication 2 est adapté pour passer les phases cadencées élevées sélectionnées de la première ligne d'alimentation électrique cadencée à sa sortie.

4. Circuit de registre à décalage selon la revendication 3, dans lequel chaque phase comprend :
une première entrée (Rₙ₋₁) connectée à la sortie d'une phase précédente ;
un transistor d'attaque (T_{drive}) pour coupler une première tension de ligne électrique cadencée (Pₐ) à la sortie (Rₙ) de la phase ;
un condensateur de compensation (C₁) pour compenser les effets d'une capacitance parasite du transistor d'attaque et connecté à une borne à une version inversée (invPₙ) de la première tension de ligne électrique cadencée ; et
un premier condensateur d'amorçage (C₂) connecté entre la grille du transistor d'attaque et la sortie (Rₙ) de la phase,
dans lequel l'inverseur est formé sur le substrat commun.

5. Circuit de registre à décalage selon la revendication 4, dans lequel l'inverseur comprend un transistor **d'excursion haute** (70) connecté entre la sortie de l'inverseur et un rail de haute tension et un transistor **d'excursion basse** (72) connecté entre la sortie de l'inverseur et un rail de basse tension.

6. Circuit de registre à décalage selon la revendication 5, dans lequel le transistor **d'excursion basse** (72) est sélectionné à travers une porte par la première tension de ligne électrique cadencée.

7. Circuit de registre à décalage selon les revendications 5 ou 6, dans lequel les transistors **d'excursion haute et d'excursion basse** opèrent avec un cycle de charge d'environ 50 %.

8. Circuit de registre à décalage selon l'une quelconque des revendications 5 à 7, dans lequel le transistor **d'excursion basse** (72) est plus grand que le transistor **d'excursion haute** (70).

9. Circuit de registre à décalage selon l'une quelconque des revendications 5 à 8, dans lequel les transistors **d'excursion haute et d'excursion basse** sont conçus pour cesser de fonctionner par vieillissement à approximativement le même moment (78).

10. Circuit de registre à décalage selon l'une quelconque des revendications 5 à 9, dans lequel une fois que l'inverseur cesse de fonctionner (78), une partie de la première tension de ligne électrique cadencée est couplée à la sortie par l'intermédiaire d'une capacitance parasite (C_{GD}) du transistor **d'excursion basse** (72), qui est dominant sur une capacitance parasite du transistor **d'excursion haute**.

11. Circuit de registre à décalage selon l'une quelconque des revendications 4 à 10, dans lequel chaque phase comprend également :
un transistor d'entrée (Tᵢₙ₁) pour charger le premier condensateur d'amorçage (C₂) et contrôlé par la première entrée (Rₙ₋₁).

12. Circuit de registre à décalage selon l'une quelconque des revendications 4 à 11, dans lequel chaque phase comprend également une section d'entrée (10) couplée à la sortie (Rₙ₋₂) de la phase deux phases ou plus avant la phase, et dans lequel la section d'entrée comprend un second condensateur d'amorçage (C₃) connecté entre la grille du transistor d'entrée (Tᵢₙ₁) et la première entrée (Rₙ₋₁).

13. Circuit de registre à décalage selon la revendication 12, dans lequel la section d'entrée est couplée à la sortie (Rₙ₋₂) de la phase deux phases avant la phase.

14. Circuit de registre à décalage selon l'une quelconque des revendications 4 à 13, dans lequel chaque phase comprend également une seconde entrée (Rₙ₊₁) connectée à la sortie de la phase suivante.

15. Circuit de registre à décalage selon l'une quelconque des revendications 4 à 14, dans lequel le condensateur de compensation (C₁) de chaque phase est connecté entre la grille du transistor d'attaque et la version inversée (invPₙ) de la première tension de ligne électrique cadencée.

16. Circuit de registre à décalage selon l'une quelconque des revendications précédentes, mis en oeuvre en utilisant une technologie de silicium amorphe.

17. Dispositif d'affichage à matrice active, comprenant :
un ensemble de pixels d'affichage à matrice active ;
un circuit d'attaque de rangée comprenant un circuit de registre à décalage selon l'une quelconque des revendications 3 à 15.

18. Un dispositif d'affichage à matrice active selon la revendication 17, comprenant un dispositif d'affichage à cristaux liquides à matrice active.

19. Procédé d'utilisation du circuit, le circuit étant selon la revendication 1, ledit procédé comprenant :
l'utilisation de la seconde partie de circuit (54) pour générer une seconde entrée (invPₙ) à partir d'une première entrée (Pₙ) ;
le contrôle de la première partie de circuit (52) en utilisant la première et la seconde entrée pour fournir les premières caractéristiques de fonctionnement ;
**caractérisé par** l'arrêt du fonctionnement de la seconde partie de circuit (54) par le vieillissement de la seconde partie de circuit, avant la fin de la durée de vie de la première partie de circuit (52), contrôlant ainsi la première partie de circuit sans la seconde entrée, et fournissant ainsi les secondes caractéristiques de fonctionnement.

20. Procédé de génération de plusieurs sorties de circuit de registre à décalage de phase, comprenant, pour chaque phase du circuit de registre à décalage, l'utilisation du procédé selon la revendication 19, dans lequel le procédé comprend l'utilisation de la sortie de la phase une ou plusieurs phases avant la phase pour charger la grille d'un transistor d'attaque (T_{drive}) à travers un transistor d'entrée (Tᵢₙ₁) et pour charger un premier condensateur d'amorçage (C₂) stockant la tension grille-source du transistor d'attaque ; et
le couplage d'une première tension de ligne d'alimentation électrique cadencée (Pₙ) à la sortie de la phase par l'intermédiaire du transistor d'attaque, la tension de la première ligne d'alimentation électrique cadencée comprenant la première entrée,
et dans lequel la seconde entrée comprend une version inversée (invPₙ) de la première tension de ligne électrique cadencée, la seconde partie de circuit comprenant un inverseur (70, 72) pour générer la version inversée de la première tension de ligne électrique cadencée, et dans lequel la seconde entrée (invPₙ) est couplée par l'intermédiaire d'un condensateur de compensation (C₁) à la grille du transistor d'attaque.

21. Procédé selon la revendication 20, dans lequel l'arrêt de l'utilisation comprend l'emploi de l'inverseur (70, 72) pour une durée suffisante pour que le vieillissement des composants de l'inverseur entraîne une défaillance de la fonction de l'inverseur.

22. Procédé selon les revendications 20 ou 21, comprenant également l'utilisation de la sortie (Rₙ₋₂) de la phase deux ou plusieurs phases avant la phase pour charger la grille d'un transistor d'entrée (Tₙ₋₁), et stocker la tension grille-source sur un second condensateur d'amorçage (C₃).
